# EUROPEAN PATENT APPLICATION

(11) **EP 4 809 902 A1**
(43) Date of publication of application: **23.09.2026**
(21) Application number: 24894536.2
(22) Date of filing: 15.11.2024
(51) Int. Cl.: A47L 15/44, A47L 15/42, G01R 33/02, F04B 43/12, F04B 49/06

(54) **DISHWASHER**

(30) Priority: 20.11.2023 KR 20230161326
(71) Applicant: LG Electronics Inc., Yeongdeungpo-gu Seoul 07336 (KR)
(72) Inventor: LEE, Sunghun, Seoul 08592 (KR); LEE, Minhyuk, Seoul 08592 (KR); SONG, Woongsup, Seoul 08592 (KR)
(74) Representative: Schott, Jakob Valentin
(86) International application number: PCT/KR2024/018108
(87) International publication number: WO 2025/110643

(57) **Abstract**

The present disclosure relates to a dishwasher. The dishwasher of the present disclosure comprises: a tub that forms a washing space in which dishes are placed, and has one open side; a door that is arranged on one side of the tub, and opens and closes the one open side of the tub; and a detergent supply device that supplies detergent to the washing space. The detergent supply device comprises: a detergent tank that forms a storage space in which detergent is stored; a housing that forms a mounting space in which the detergent tank is mounted; a pump that is mounted on one side of the detergent tank, and sends the detergent stored in the storage space to the washing space; and a motor that is disposed on one side of the housing and operates the pump. The pump comprises: a pump tube that is connected to the detergent tank to supply the detergent stored in the detergent tank to the washing space; and a plurality of pressure rollers that are connected to the motor to rotate, and pressurize one side of the pump tube. The pump tube has a partial area disposed horizontally, which sends the detergent that flows by means of the pressure rollers to a discharge port of the detergent tank.

## Description

### [Technical Field]

The present disclosure relates to a dishwasher, and more specifically, to a dishwasher that supplies a detergent using a pump.

### [Background Art]

A dishwasher is a device that washes, rinses, and dries dishes to remove dirt and grime adhering to dishes. For washing, a dishwasher dispenses detergent solution or detergent powder into a dispenser located inside the dishwasher.

However, there is the inconvenience of having to manually add a detergent or the like every time the dishwasher is used. Furthermore, since the addition of a detergent or the like is performed manually by the user each time, the amount of detergent added may vary.

To solve these problems, dishwashers including a detergent supply device that stores a certain amount of detergent and supplies only a portion of the detergent during the washing process are being developed.

European Patent Publication EP 3888521 A1 discloses a dishwasher including a detergent supply device that supplies a certain amount of detergent to a tub by pressurizing a tube.

However, the disclosed dishwasher has a structure in which the motor operating the pump is not easily detachable. Furthermore, in this structure, even when the pump stops, a problem may arise where a detergent leaks from the tube disposed vertically to a discharge port. Additionally, in this structure, there may be a problem where the detergent hardens in the tube disposed inside the pump. Furthermore, in this structure, a problem may arise where precise control of the pump by the motor is difficult.

Further, in the structure, a tank in which detergent is stored is mounted on one side of a door and is temporarily coupled, and thus coupling or a connection between a detergent tank and a housing accommodating the detergent tank may be affected by an external impact or the like.

### [Disclosure]

### [Technical Problem]

An object of the present disclosure is to provide a dishwasher in which a connection relationship between a detergent tank and a housing can be stably maintained during a process in which the detergent tank is mounted on the housing or after the detergent tank is mounted. Moreover, an object thereof is to provide a dishwasher in which detection by a sensor configured to detect operation of the detergent tank is stably performed in a state in which the detergent tank is mounted on the housing.

Another object to be achieved by the present disclosure is to provide a dishwasher that minimizes leakage of detergent present in a pump.

Still another object of the present disclosure is to provide a dishwasher that prevents detergent present inside a pump from hardening.

Still another object of the present disclosure is to provide a dishwasher that precisely controls a pump to supply detergent to a tub.

Still another object of the present disclosure is to provide a dishwasher including a compact detergent supply device.

Objects of the present disclosure are not limited to those mentioned above, and other unmentioned objects will be clearly understood by those skilled in the art from the description below.

### [Technical Solution]

In order to achieve the above-described objects, a dishwasher according to an embodiment of the present disclosure includes a tub that forms a washing space in which dishes are placed and has one open side, a door that is arranged on one side of the tub and opens and closes the one open side of the tub, and a detergent supply device that supplies detergent to the washing space, thereby supplying a predetermined amount of detergent into the tub.

The detergent supply device includes a detergent tank that forms a storage space in which detergent is stored, a housing that forms a mounting space in which the detergent tank is mounted, a pump that is mounted on one side of the detergent tank, and sends the detergent stored in the storage space to the washing space, and a motor that is disposed one side of the housing and operates the pump, thereby supplying detergent stored in the easily mounted detergent tank to the tub.

The door includes an inner door disposed to face the washing space and an outer door positioned outside the inner door. The inner door includes a protrusion on which the housing is disposed and a recessed portion disposed closer to the outer door than the protrusion. The housing includes a first housing body, a second housing body disposed on one side of the first housing body, and a stepped portion disposed to form a step between the first housing body and the second housing body. An end portion of the stepped portion is disposed between a surface formed by the protrusion and a surface formed by the recessed portion, such that the stepped portion can distribute a load of the detergent tank. In addition, due to the stepped portion, the detergent tank can be stably coupled to the housing and maintained in a coupled state.

The second housing body may be provided with a device that detects a state of the detergent tank or the pump or is linked to the detergent tank or the pump.

The device may include one of a detection sensor for detecting operation of the pump, a temperature sensor for detecting a temperature of detergent discharged from the detergent tank, and a transmission gear connected to the pump. As the detergent tank is mounted on the housing, the detergent tank and the housing may be organically coupled by the device.

The second housing body may be positioned below the first housing body.

The device may protrude from the second housing body in a direction in which the detergent tank is disposed.

The protrusion may include an installation portion on which an additional detergent supply device is disposed, and the installation portion may be disposed closer to the outer door than the protrusion.

The pump may include a pump tube that is connected to the detergent tank to supply the detergent stored in the detergent tank to the washing space, and a plurality of pressure rollers that are connected to the motor to rotate and pressurize one side of the pump tube, such that detergent flows through the pump tube according to rotation of the pressure rollers. Moreover, the pump tube may have a partial area disposed horizontally, which sends the detergent flowing by the pressure rollers to a discharge port of the detergent tank, such that detergent in the pump tube is not discharged to the outside even when the motor is stopped.

The pump tube may include an extrusion tube disposed in an area in contact with the plurality of pressure rollers, an inlet tube for connecting one side of the extrusion tube and the storage space of the detergent tank, and an outlet tube for connecting the other side of the extrusion tube and a discharge port of the detergent tank, and the outlet tube may be disposed parallel to the ground, thereby preventing detergent present in the outlet tube from being discharged through the discharge port due to gravity or the like.

The outlet tube may be disposed above the inlet tube, thereby allowing detergent present at a lower portion of the detergent tank to be introduced and discharged.

An inner diameter of the pump tube may be formed to be 1 mm or more and 5 mm or less, thereby preventing detergent inside the pump tube from hardening.

An outer diameter of the pump tube is formed to be 10 mm or less, thereby preventing detergent inside the pump tube from hardening.

The detergent tank includes a connection port connected to the pump disposed on one side thereof, the connection port is provided with an inlet flow path connecting the storage space and the pump tube, and an outlet flow path connecting the pump tube and the washing space, and the outlet flow path is disposed above the inlet flow path.

A discharge port opened toward the storage space is formed at one end of the outlet flow path, and the discharge port is disposed to be spaced upward from the inlet flow path.

The dishwasher may further include a temperature sensor that detects a temperature of detergent discharged through the discharge port, and the temperature sensor is disposed below the discharge port to detect the temperature of the detergent discharged through the discharge port.

The dishwasher may further include a transmission gear configured to transmit a driving force generated from the motor to the pump, the pump is provided with a gear groove into which a portion of the transmission gear is inserted, and when the detergent tank is mounted on the housing, the motor into which a portion of the transmission gear is inserted is connected to the gear groove formed in the pump.

The motor includes a motor shaft and a motor gear protruding in a screw shape from an outer circumference of the motor shaft, and the transmission gear includes a transmission gear shaft disposed perpendicular to the motor shaft, a first gear disposed on one side of the transmission gear shaft and engaged with the motor gear, and a second gear disposed on the other side of the transmission gear shaft and connected to the pump, thereby rotating the pump with a small driving force of the motor.

The dishwasher may include a floater configured to detect a level of detergent stored in the storage space, and the connection port may be disposed below the floater.

A detergent supply device of a dishwasher of the present disclosure includes a detergent tank that forms a storage space in which detergent is stored, a housing that forms a mounting space in which the detergent tank is mounted, a pump that is disposed on one side of the detergent tank, and sends the detergent stored in the storage space to the washing space, a motor that is disposed on one side of the housing and operates the pump, and a transmission gear that transmits a driving force of the motor to the pump, thereby transmitting a driving force of the motor to the transmission gear. Moreover, the motor a motor shaft configured to rotate when driven and a motor gear forming a screw-shaped thread on a circumferential surface of the motor shaft, and the transmission gear includes a transmission gear shaft disposed perpendicular to the motor shaft, a first gear disposed on one side of the transmission gear shaft and engaged with the motor gear, and a second gear disposed on the other side of the transmission gear shaft and connected to the pump, thereby transmitting a rotational force of the motor in the perpendicular direction.

The pump may include a pump tube connected to the detergent tank and forming a space through which the detergent flows, a pressure roller that pressurizes one side of the pump tube to cause the detergent inside the pump tube to flow, and a rotor configured to rotate the pressure roller, the rotor being provided with a gear groove at one side thereof into which the transmission gear is inserted.

An inner circumferential surface of the gear groove is provided with a plurality of inner protrusions protruding inward, and the second gear is provided with a plurality of outer protrusions protruding from an outer peripheral surface of the transmission gear shaft while being spaced apart from each other in a circumferential direction, such that the pump and the transmission gear engage with each other.

A thickness formed by the plurality of outer protrusions in the circumferential direction is smaller than a spacing between the plurality of outer protrusions such that the transmission gear is easily inserted into the gear groove.

A thickness of each of the plurality of outer protrusions is smaller than a spacing between the plurality of inner protrusions such that the transmission gear is easily inserted into the gear groove.

The motor gear has a worm gear shape, and the first gear is formed in a worm wheel shape, such that a driving force is transmitted to the transmission gear disposed in a perpendicular direction.

A detergent supply device of a dishwasher of the present disclosure a detergent tank that forms a storage space in which detergent is stored, a housing that forms a mounting space in which the detergent tank is mounted, a pump that is mounted on one side of the detergent tank, and sends the detergent stored in the storage space to the washing space, and a motor that is disposed on one of the housing and operates the pump, and the detergent tank include a tank case forming the storage space therein and provided with an inlet hole at one side thereof and a discharge port at the other side thereof, a floater disposed to be movable upward and downward inside the tank case and configured to detect a level of the storage space, and a connection port connected to the pump to discharge detergent stored in the storage space. The storage space of the housing is partitioned into an inlet area in which the inlet hole is formed, a level checking area disposed below the inlet area and in which the floater is disposed, and a discharge area disposed below the level checking area and in which the connection port is disposed, and the discharge area is disposed below the level checking area.

The pump is disposed on one side of the discharge area, thereby minimizing a space gathered toward the discharge area. In addition, a compact arrangement of the pump and the detergent tank may be formed.

The pump includes a pump tube connected to the detergent tank and supplying detergent stored in the detergent tank to the washing space, and a plurality of pressure rollers connected to the motor and rotating to pressurize one side of the pump tube, and the pump tube includes an extrusion tube disposed in an area contacting the plurality of pressure rollers, an inlet tube connecting one side of the extrusion tube and the storage space of the detergent tank, and an outlet tube connecting the other side of the extrusion tube and the discharge port of the detergent tank, and the outlet tube is disposed above the inlet tube. The inlet tube may be disposed at a lower side to suck detergent in a lower area of the discharge area, and the outlet tube may be horizontally disposed.

A pump of the present invention includes a pump tube connected to the detergent tank and supplying detergent stored in the detergent tank to the washing space, and a plurality of pressure rollers connected to the motor and rotating to pressurize one side of the pump tube. The detergent supply device may include a detection sensor configured to detect operation of the pump, and the detection sensor may be installed on the housing.

The detection sensor may be installed at a rear side of the housing.

The housing may be provided with a detection sensor mounting portion protruding forward in an area in which the detection sensor is disposed. The housing may include a first housing body and a second housing body disposed on one side of the first housing body and protruding outward relative to the first housing body, and the detection sensor may be installed in the second housing body.

The second housing body may protrude lower than the first housing body.

The pump may include a magnet rotating together according to rotation of the pressure roller, and the detection sensor may determine a rotation state and an operation state of the pump by detecting a change in magnetic force of the magnet.

Specific details of other embodiments are included in the detailed description and drawings.

### [Advantageous Effects]

According to the dishwasher of the present disclosure, there is one or more of the following effects.

First, a state in which the detergent tank is disposed can be stably maintained in a state in which the detergent tank is mounted on the housing. Accordingly, a connection relationship between the detergent tank and the housing can be stably maintained. In addition, coupling between organically coupled configurations while the detergent tank is mounted on the housing can be stably maintained. Such a structure has an advantage in that detection by a sensor configured to detect the operation of the detergent tank or discharge of detergent can be stably maintained. In addition, there is an advantage in that reliability of a configuration organically operating through coupling between the detergent tank and the housing is improved.

That is, the present disclosure provides a dishwasher in which the detergent tank can be stably coupled to the housing even by an external impact or the like.

Second, the tube positioned in an area in which the detergent is discharged from the pump is horizontally disposed, thereby providing an advantage in that leakage of detergent present in the tube to the outside can be minimized even in a state in which rotation of the pump is stopped.

Third, there is also an advantage in that hardening of detergent inside the tube can be prevented by adjusting a diameter of a pump tube disposed inside the pump.

Fourth, a worm gear is used for the motor shaft connected to the motor to transmit a driving force to the pump through the transmission gear having a worm wheel structure. In such a structure, fine movement of the pump is implemented even by multiple rotations of the motor, thereby providing an advantage in that fine control of the pump can be performed. In addition, there is also an advantage in that the pump can operate even with a small driving force of the motor.

Fifth, through arrangement of the pump and the motor, the detergent supply device can have a compact structure. This provides an advantage in that the detergent supply device can be disposed using a small space.

Effects of the present disclosure are not limited to those mentioned above, and other unmentioned effects will be clearly understood by those skilled in the art from the description in the claims.

### [Description of Drawings]

FIG. 1 is a view of a dishwasher with a door open according to one embodiment of the present disclosure.
FIG. 2 is a perspective view from one side of a part of the door in which a detergent supply device is disposed according to one embodiment of the present disclosure.
FIG. 3 is a perspective view from one side illustrating a state in which a detergent tank of the detergent supply device is separated according to one embodiment of the present disclosure.
FIG. 4 is a perspective view from the other side illustrating a state in which the detergent tank of the detergent supply device is separated according to one embodiment of the present disclosure.
FIG. 5 is an exploded perspective view of the detergent tank and a pump according to one embodiment of the present disclosure.
FIG. 6 is a front view of the detergent tank according to one embodiment of the present disclosure.
FIG. 7 is a rear perspective view of the detergent tank according to one embodiment of the present disclosure.
FIG. 8 is a perspective view of a cross section taken from one side of the detergent tank according to one embodiment of the present disclosure.
FIG. 9 is a diagram for explaining a flow path inside a connection port according to one embodiment of the present disclosure.
FIG. 10 is a rear perspective view illustrating a state in which the pump is mounted to the detergent tank according to one embodiment of the present disclosure.
FIG. 11 is a perspective view of the pump according to one embodiment of the present disclosure.
FIG. 12a is a view for explaining the internal structure of a pump according to one embodiment of the present disclosure.
FIG. 12b is a view for explaining the internal structure of a pump according to another embodiment of the present disclosure.
FIG. 13 is a view illustrating a state in which a transmission gear is inserted into the pump of FIG. 12a.
FIG. 14 is an exploded perspective view of a housing and a motor according to one embodiment of the present disclosure.
FIG. 15 is a perspective view for explaining the motor and the transmission gear according to one embodiment of the present disclosure.
FIG. 16 is a view illustrating a cross-section of a second gear of the transmission gear according to one embodiment of the present disclosure.
FIG. 17 is a perspective view for explaining a motor, a transmission gear, and a pump according to one embodiment of the present disclosure.
FIG. 18 is a cross-sectional view from one side for explaining the connection relationship or the like in a state where the detergent tank is mounted to a housing according to one embodiment of the present disclosure.
FIG. 19 is a perspective view of a cross-section taken from one side of the housing according to one embodiment of the present disclosure.
FIG. 20 is a cross-sectional view illustrating the separated state of the detergent tank and the housing in an area where a temperature sensor is disposed according to one embodiment of the present disclosure.
FIG. 21 is a cross-sectional view illustrating the state in which the detergent tank is mounted to the housing in the area where the temperature sensor is disposed according to one embodiment of the present disclosure.
FIG. 22a is a view schematically illustrating arrangement of a first housing body and a second housing body according to a first embodiment of the present disclosure.
FIG. 22b is a view schematically illustrating arrangement of a first housing body and a second housing body according to a second embodiment of the present disclosure.
FIG. 22c is a view schematically illustrating arrangement of a first housing body and a second housing body according to a third embodiment of the present disclosure.
FIG. 22d is a view schematically illustrating arrangement of a first housing body and a second housing body according to a fourth embodiment of the present disclosure.

### [Mode for Invention]

The advantages and features of the present disclosure and the methods for achieving them will become clear by referring to the embodiments described below in detail together with the accompanying drawings. However, the present disclosure is not limited to the embodiments disclosed below and may be implemented in various different forms. The embodiments are provided only to make the disclosure of the present disclosure complete and to fully inform those skilled in the art to which the present disclosure pertains of the scope of the invention, and the present disclosure is defined only by the scope of the claims. Throughout the specification, the same reference numerals refer to the same components.

Hereafter, the present disclosure will be described with reference to the drawings for explaining a dishwasher according to the embodiments of the present disclosure.

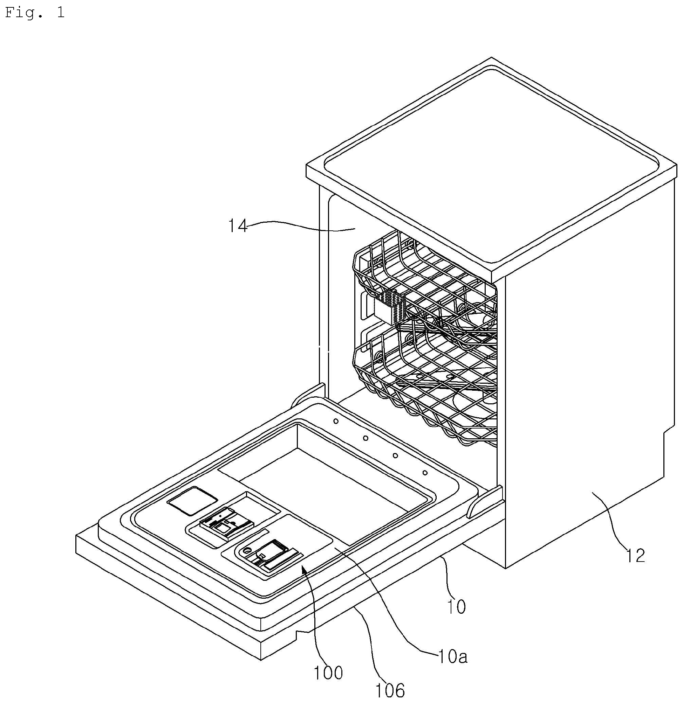

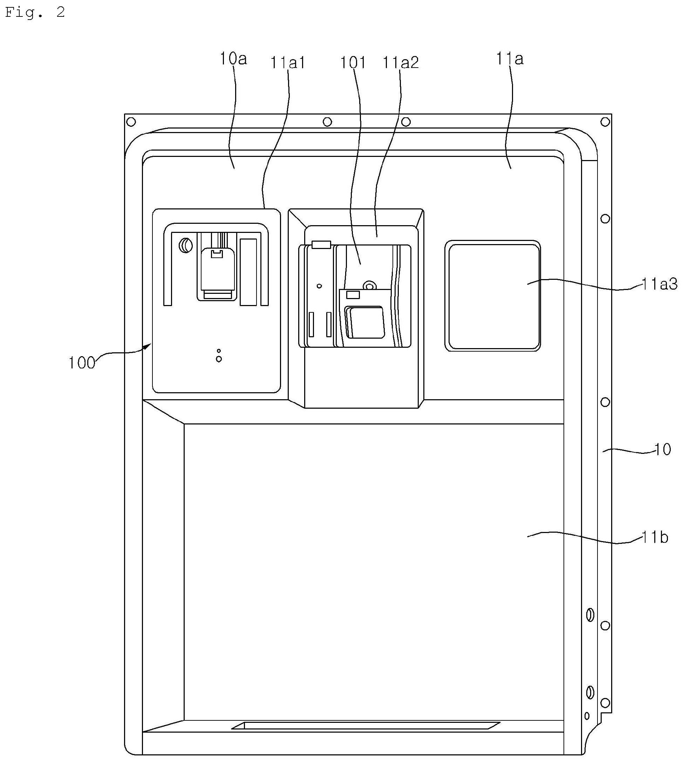

With reference to FIGS. 1 and 2, the overall configuration of a dishwasher and a detergent supply device 100 will be described.

The dishwasher includes a cabinet 12 that forms an outer shape and an inner washing space, a door 10 that opens and closes one open side of the cabinet 12, and a detergent supply device 100 (or "first detergent supply device") that is disposed on inside the door 10 and supplies a detergent to the washing space.

The dishwasher may include a tub 14 that forms a space for washing dishes, a sump (not illustrated) that is disposed below the tub and stores washing water, and a pump (not illustrated) that supplies the washing water stored in the sump to the tub. Additionally, the dishwasher may include a spray arm (not illustrated) that is disposed inside the tub 14 and sprays washing water into the washing space.

The door 10 includes an outer door 10b and an inner door 10a. The outer door 10b is disposed so as to be exposed to the outside when the door 10 closes one side of the cabinet 12. The inner door 10a may be disposed to face the washing space of the tub 14 when the door 10 closes one side of the cabinet 12.

A spaced space may be formed between the inner door 10a and the outer door 10b. The wall surface formed by the inner door 10a and the wall surface formed by the outer door 10b may be disposed spaced apart from each other.

Referring to FIG. 2, the inner door 10a includes a protrusion 11a where the detergent supply device 100 is disposed, and a recessed portion 11b disposed below the protrusion 11a and forming a groove in the direction in which the outer door 10b is disposed.

The inner door 10a includes a protrusion 11a where a housing 200 is disposed, and a recessed portion 11b disposed closer to the outer door 10b than the protrusion 11a.

The recessed portion 11b may secure a washing space for the tub 14. Accordingly, an area occupied by dishes disposed in the washing space may be more widely secured.

The protrusion 11a may form a surface that protrudes toward the tub 14 relative to the recessed portion 11b. Therefore, the detergent supply device 100 may be disposed in the protrusion 11a.

The protrusion 11a includes a first installation portion 11a1 in which the detergent supply device 100 is disposed. The protrusion 11a may include a second installation portion 11a2 disposed on one side of the first installation portion 11a1. The protrusion 11a may include a third installation portion 11a3 disposed on one side of the first installation portion 11a1 or the second installation portion 11a2.

The detergent supply device 100 is disposed in the first installation portion 11a1. The second installation portion 11a2 is disposed on one side of the first installation portion 11a1 and may be disposed spaced apart from the first installation portion 11a1 in the direction of the outer door 10b. A second detergent supply device 101 may be disposed in the second installation portion 11a2. The second detergent supply device 101 may be disposed protruding from the second installation portion 11a2.

The second detergent supply device 101 in which a device door 101a is opened during the operation of the dishwasher may be disposed in the protrusion 11a. The second detergent supply device 101 may be a detergent supply device that supplies a certain amount of detergent before the operation of the dishwasher and discharges the detergent stored inside when the device door 10 is opened during the operation of the dishwasher. The second detergent supply device 101 may not be a structure in which the entire structure is inserted into the space between the inner door 10a and the outer door 10b. Therefore, a portion of the second detergent supply device 101 may have a structure that protrudes into the inner side of the tub 14. However, the second installation portion 11a2 may form a surface recessed relative to the surface formed by the protrusion 11a to minimize the portion of the second detergent supply device 101 that protrudes into the inner space of the tub 14.

The third installation portion 11a3 may be disposed on one side of the second installation portion 11a2. The third installation portion 11a3 may also form a surface spaced apart in the direction in which the outer door 10b is disposed. However, the third installation portion 11a3 may be disposed closer to the direction in which the tub 14 is disposed than the second installation portion 11a2.

Although not illustrated in the drawings, an additional detergent supply device (not illustrated) may be disposed in the third installation portion. The additional detergent supply device may be a detergent supply device having a configuration similar to that of the second detergent supply device 101. In the third installation portion 11a3, an additional detergent supply device may be disposed in a structure into which it is inserted. The second installation portion 11a2 and the third installation portion 11a3, where the additional detergent supply device is installed, may be disposed closer to the outer door 10b than the surface formed by the protrusion 11a.

Referring to FIG. 2, the detergent supply device 100 is disposed on the inside of the door 10. Accordingly, the detergent discharged from the detergent supply device (20) may be introduced into the washing space formed inside the cabinet 12. However, as another embodiment, the detergent supply device 100 may be disposed at another portion inside the cabinet 12 rather than on the door 10. That is, it is also possible for the detergent supply device 100 to be disposed on one side of the tub.

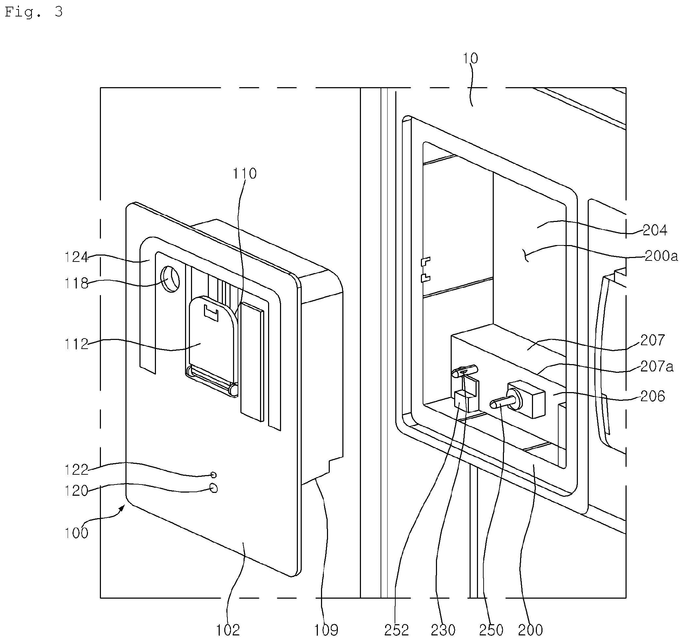

Referring to FIG. 3, a detergent tank 102 and the housing 200 of the detergent supply device 100 will be described.

The detergent supply device 100 includes the detergent tank 102 that forms a storage space 103 in which detergent is stored, and the housing 200 on which the detergent tank 102 is mounted. The housing 200 may be disposed on one side of the door 10.

The detergent tank 102 forms the storage space 103 in which detergent is stored. An inlet 110 for injecting detergent into the storage space 103 is formed on one side of the detergent tank 102. An inlet cover 112 for opening and closing the inlet 110 is disposed on one side of the detergent tank 102. The inlet cover 112 may be hinge-fixed to one side of the detergent tank 102.

A handle 124 may be disposed on one side of the detergent tank 102. The handle 124 may be rotatably disposed on one side of the detergent tank 102. A discharge port 122 through which the detergent stored in the storage space 103 is discharged is formed on one side of the detergent tank 102. The discharge port 122 is disposed below the inlet 110.

A sensor cover 120 is disposed on one side of the detergent tank 102. The sensor cover 120 prevents a temperature sensor 250, which will be described below, from being exposed to the outside. The sensor cover 120 is disposed below the discharge port 122. The sensor cover 120 may have a structure that protrudes from the detergent tank 102.

A communication hole 118 may be formed on one side of the detergent tank 102. The communication hole 118 may be disposed above the inlet 110.

The housing 200 may form a mounting space 200a in which the detergent tank 102 is mounted. The detergent tank 102 is inserted into the mounting space 200a formed in the housing 200.

The mounting space 200a may be formed in a shape corresponding to the portion on which the detergent tank 102 is mounted.

A transmission gear 230 that transmits power to a pump 160, which will be described below, is disposed to protrude in the housing 200. Therefore, when the detergent tank 102 is mounted to the housing 200, one side of the transmission gear 230 can be inserted into the pump 160.

The temperature sensor 250 is disposed to protrude in the housing 200. Therefore, when the detergent tank 102 is mounted to the housing 200, the temperature sensor 250 may be inserted into one side of the detergent tank 102.

A detection sensor 252 for detecting the operation of the pump 160, which will be described below, is disposed in the housing 200. The detection sensor 252 may be disposed at the rear of the housing 200. The detection sensor 252 may be disposed so as to protrude in the direction in which the detergent tank 102 is mounted.

A stepped portion 207 is formed in the housing 200. The housing 200 includes a first housing body 204 that forms a space in which a first tank body 106, which will be described below, is disposed, and a second housing body 206 that forms a space in which a second tank body 108, which will be described below, is disposed. The stepped portion 207 is formed between the first housing body 204 and the second housing body 206.

The housing 200 includes the first housing body 204, the second housing body 206 disposed on one side of the first housing body 204, and the stepped portion 207 partitioning the first housing body 204 and the second housing body 206.

The detergent tank 102 also has a stepped portion 109 corresponding to the stepped portion 207 of the housing 200. In the detergent tank 102, the corresponding stepped portion 109 is formed due to the height difference between the first tank body 106 and the second tank body 108 protruding inward from the door 10.

When the detergent tank 102 is inserted into the housing 200, the corresponding stepped portion 109 of the detergent tank 102 may be disposed to catch on the stepped portion 207 of the housing 200. The above structure can prevent the detergent tank 102 mounted to the housing 200 from moving or shaking inside the housing 200.

The structure of the stepped portion 207 of the housing 200 can maintain the stable positioning of the temperature sensor 250, the transmission gear 230, and a detection sensor mounting portion 210 protruding from the housing 200.

In addition, the stepped portion 207 may guide the detergent tank 102 inserted into the housing 200. The stepped portion 207 may guide the temperature sensor 250, the transmitter 230, and the detection sensor mounting portion 210 to be inserted into the correct position of the detergent tank 102.

Accordingly, it is possible to prevent the temperature sensor 250, the transmitter 230, and the detection sensor mounting portion 210 from being damaged by movement caused by external influences during the insertion process of the detergent tank 102 or in a state the detergent tank is inserted.

An end portion 207a of the stepped portion 207 may be disposed between the surface formed by the protrusion 11a and the surface formed by the recessed portion 11b.

The end portion 207a of the stepped portion 207 may be disposed to protrude outward relative to the surface formed by the recessed portion 11b. Additionally, the end portion 207a of the stepped portion 207 may be disposed inward relative to the surface formed by the protrusion 11a. Here, the end portion 207a of the stepped portion 207 may refer to the end of the portion where the stepped portion 207 protrudes. Here, the outer side may refer to the direction in which the inner door 10a is disposed relative to the outer door 10b, and the inner side may refer to the direction opposite to the outer side.

The stepped portion 207 may form a stepped structure toward the upper side inside the housing 200 and perform the function of supporting a portion of the load of the detergent tank 102. Therefore, even when multiple components are disposed in the detergent tank 102, the structural stability of the detergent tank 102 mounted to the housing 200 can be increased because the stepped portion 207 supports a portion of the load.

A device that detects the detergent tank 102 or is linked to the detergent tank 102 may be disposed in the second housing body 206. A device that detects the pump 160 or is linked to the pump 160 may be disposed in the second housing body 206.

The device may be the detection sensor 252, the temperature sensor 250, and the transmission gear 230 to be described below. The device may be disposed so as to protrude from the second housing body 206 into the area in which the detergent tank 102 is disposed.

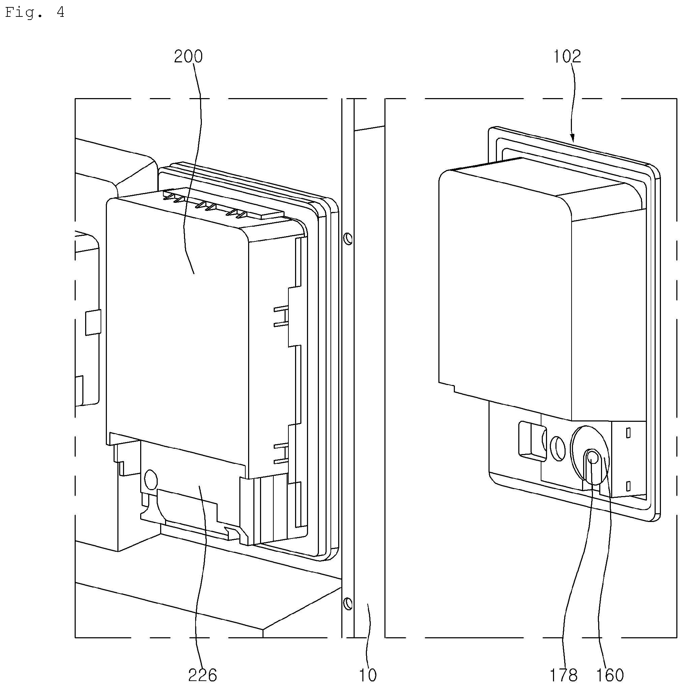

With reference to FIG. 4, the detergent tank 102 and the housing 200 of the detergent supply device 100 will be described.

The pump 160 is disposed on one side of the detergent tank 102. The pump 160 may be mounted to the housing 200 in a state combined with the detergent tank 102.

A gear groove 178 into which the transmission gear 230 disposed in the housing 200 is inserted is formed in the pump 160.

The housing 200 is fixedly disposed on one side of the door 10. The housing 200 may be fixedly disposed on the inner wall of the door 10. The housing 200 may be detachably disposed from the inner wall of the door 10. The inner wall of the door 10 may refer to one wall of the door that is disposed to face the tub 14 when the door 10 is closed.

A motor 220 and a motor cover 226 covering the motor 220 may be disposed on one side of the housing 200. The motor cover 226 is disposed on the lower side of the housing 200. The motor 220 and t transmission gear 230 are disposed on the lower side of the housing 200. The motor cover 226 may fix the positions of the motor 220 and the transmission gear 230 disposed on the lower side of the housing 200.

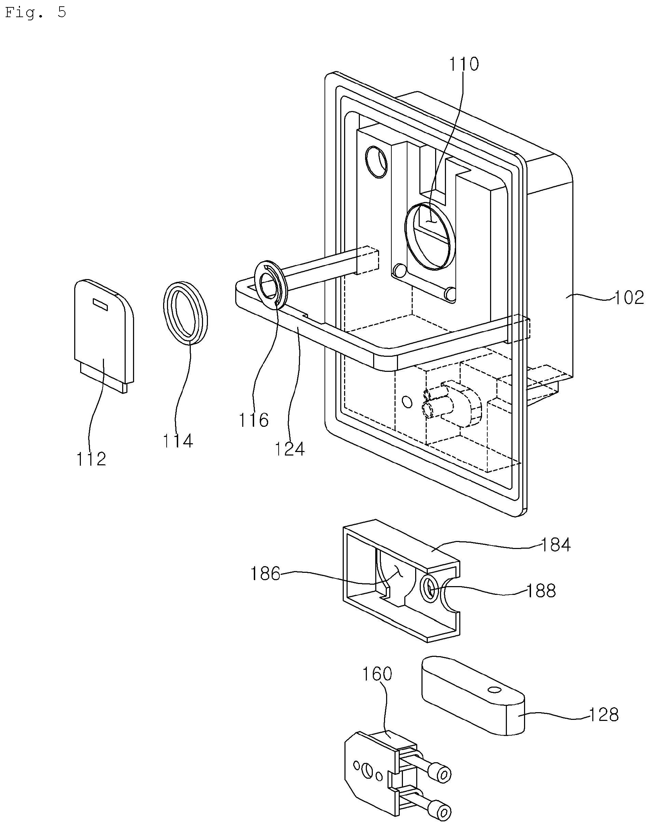

Referring to FIG. 5, the configurations of the detergent tank 102 and the pump 160 will be described.

The inlet 110 and the discharge port 122 are formed in a first wall 104 disposed in front of the detergent tank 102. The inlet cover 112 is disposed at the inlet 110. The inlet cover 112 is provided with a cover louver 114 and a cover cap 116. The cover louver 114 may seal the space between the inlet 110 and the inlet cover 112. The cover cap 116 may secure the cover louver 114 to the inlet cover 112.

A floater 128 may be disposed inside the detergent tank 102. The floater 128 may move up and down depending on the amount of detergent stored inside the detergent tank 102. The level of the detergent in the storage space 103 according to the position of the floater 128 may be checked through a separate water level sensor (not illustrated).

The pump 160 is disposed on one side of the detergent tank 102. The pump 160 may send the detergent stored in the detergent tank 102 to the washing space of the tub 14. The pump 160 is fixedly disposed on one side of the detergent tank 102. The pump 160 is mounted to the housing 200 together with the detergent tank 102.

When the detergent tank 102 and the pump 160 are mounted to the housing 200, the pump is connected to the motor 220 that operates the pump 160.

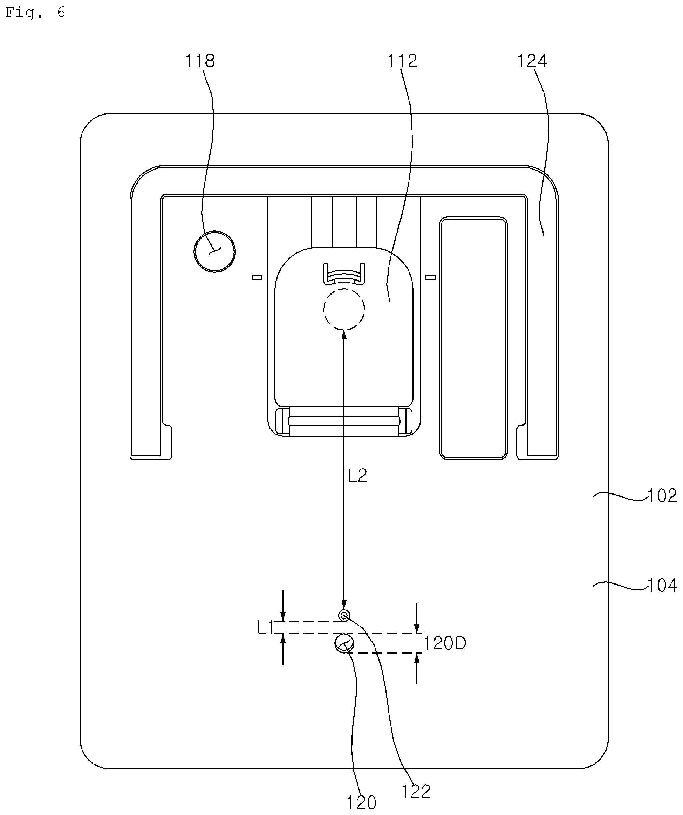

Referring to FIG. 6, the front portion of the detergent tank 102 will be described.

The first wall 104 is disposed in the direction exposed from the detergent tank 102 toward the tub 14. The first wall 104 forms a surface exposed to the outside in a state where the detergent tank 102 is mounted in the housing 200.

The first wall 104 may be disposed to face the washing space inside the tub 14 in a state where the door 10 is closed.

The handle 124 is disposed on the first wall 104. The handle 124 is rotatably disposed on the first wall 104. A user may detach the detergent tank 102 from the housing 200 through the handle 124.

The communication hole 118 is formed in the first wall 104. The communication hole 118 is disposed above the inlet 110.

The inlet 110 and the inlet cover 112 covering the inlet 110 are disposed on the first wall 104. The inlet 110 is disposed above the discharge port 122. The inlet cover 112 is rotatably disposed on the first wall 104. The inlet cover 112 may open and close the inlet 110. The user may open the inlet 110 and inject detergent into the inlet 110.

The discharge port 122 may be formed in the first wall 104. The discharge port 122 is disposed below the inlet 110. The discharge port 122 may be disposed at a certain distance upward from the lower end of the first wall 104.

The sensor cover 120 covering the temperature sensor 250, which will be described below, is disposed in the first wall 104. The sensor cover 120 is disposed below the discharge port 122. The sensor cover 120 is disposed below the discharge port 122 in an up-down direction. Therefore, the detergent discharged from the discharge port 122 may fall along the first wall 104 and pass through the sensor cover 120.

As the detergent discharged from the discharge port 122 passes through the sensor cover 120, the temperature sensor 250 may detect a temperature change.

The sensor cover 120 may be formed of a thermally conductive material. Therefore, a temperature change due to the detergent in contact with the sensor cover 120 may be quickly detected. The sensor cover 120 may be made of a metal material with high thermal conductivity. The sensor cover 120 may be formed of a material such as iron or aluminum with high thermal conductivity.

The sensor cover 120 may be disposed to protrude forward from the first wall 104. The sensor cover 120 may have a shape that is convex forward.

A spacing L1 between the sensor cover 120 and the discharge port 122 in the up-down direction may be formed to be smaller than a spacing L2 between the inlet 110 and the discharge port 122. The spacing L1 between the sensor cover 120 and the discharge port 122 may be formed to a size between 0.5 times and 2 times a diameter 120D of the sensor cover 120.

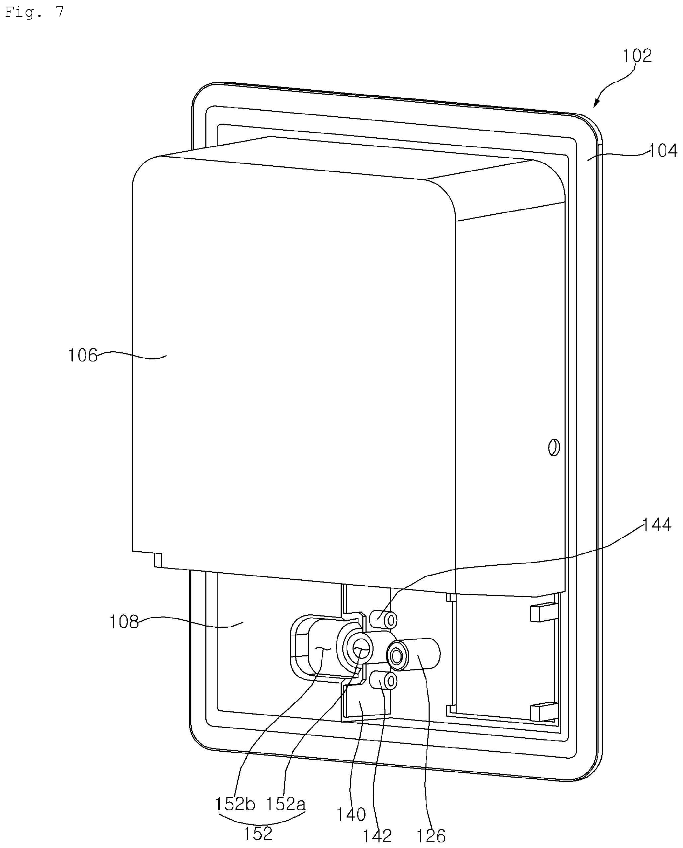

Referring to FIG. 7, the rear portion of the detergent tank 102 will be described.

The detergent tank 102 includes tank bodies 106 and 108 that protrudes rearward from the first wall 104 to form the storage space 103. The tank body includes the first tank body 106 and the second tank body 108 disposed below the first tank body 106.

The first tank body 106 is disposed above the second tank body 108. The first tank body 106 has a structure that protrudes rearward relative to the second tank body 108.

The length formed by the second tank body 108 in the left-right direction is formed to be smaller than the length formed by the first tank body 106 in the left-right direction. The length formed by the second tank body 108 in the up-down direction is formed to be smaller than the length formed by the first tank body 106 in the up-down direction. The length formed by the second tank body 108 in the front-back direction is formed to be smaller than the length formed by the first tank body 106 in the front-back direction.

The second tank body 108 forms a storage space smaller than that of the first tank body 106. The pump 160 is connected to one side of the second tank body 108. A space for the pump 160 is formed on one side of the second tank body 108.

The second tank body 108 includes a connection port 140 to which the pump 160 is connected.

The connection port 140 is configured with an inlet port 142 connected to one side of the pump 160 and an outlet port 144 connected to the other side of the pump 160. The inlet port 142 connects the inside of the detergent tank 102 and the pump 160. The outlet port 144 connects the pump 160 and the discharge port 122.

The inlet port 142 is disposed below the outlet port 144. Each of the inlet port 142 and the outlet port 144 is disposed to protrude in the direction in which the pump 160 is disposed. The inlet port 142 is connected to an inlet tube 170 of the pump 160 to be described below.

The outlet port 144 sends the detergent flowing from the pump 160 to the tub 14 through the discharge port 122. The outlet port 144 is connected to an outlet tube 172 of the pump 160 to be described below.

An inlet flow path 146 that connects the pump 160 and the storage space 103 may be formed inside the connection port 140. An outlet flow path 148 that connects the pump 160 and the outside of the detergent tank 102 may be formed inside the connection port 140.

A sensor groove 152 into which the temperature sensor 250 is inserted is formed in the connection port 140. The sensor groove 152 may be disposed between the inlet port 142 and the outlet port 144 in the up-down direction. The sensor groove 152 may be formed in the front-rear direction.

The sensor groove 152 includes a first sensor groove 152a into which the temperature sensor 250 is inserted, and a second sensor groove 152b into which a sensor mounting portion 208 surrounding a portion of the temperature sensor 250, which will be described below, is inserted. The second sensor groove 152b may be formed larger than the first sensor groove 152a.

The first sensor groove 152a may be formed inwardly at the location where the second sensor groove 152b is formed.

A fastening boss 126 to which the pump 160 or a pump cover 184 is fastened may be disposed on one side of the rear of the first wall 104.

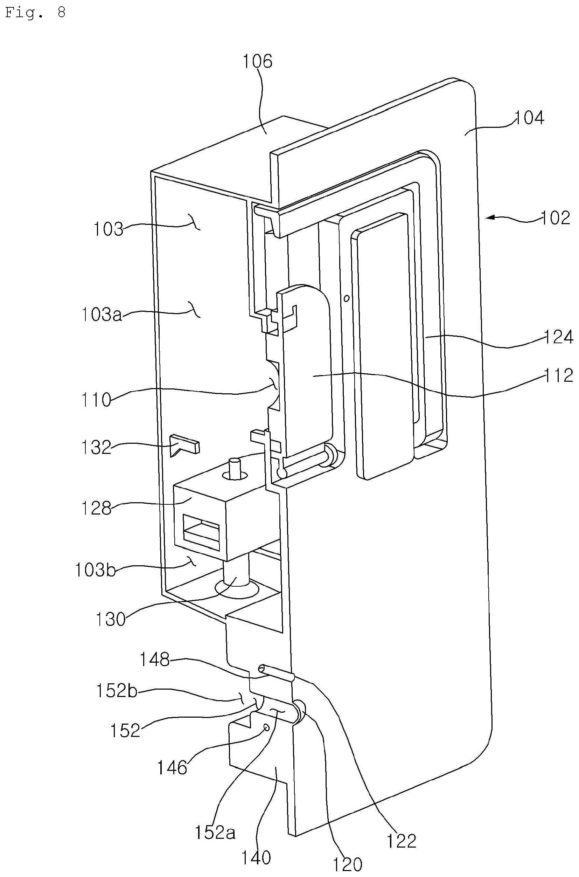

Referring to FIG. 8, the internal configuration of the detergent tank 102 and the interior of the connection port 140 will be described.

The floater 128 is disposed inside the detergent tank 102. The floater 128 may move up and down depending on the amount of detergent stored inside the storage space 103. The interior of the floater 128 may be formed as a hollow space.

A guide bar 130 formed in the up-down direction may be disposed inside the detergent tank 102 to guide the movement of the floater 128. A guide projection 132 that restricts the upward movement of the floater 128 may be disposed inside the detergent tank 102.

The interior of the first tank body 106 is divided into an inlet area 103a where the inlet 110 is formed and a water level checking area 103b where the floater 128 is disposed. A storage space inside the second tank body 108 is formed on one side of the area where the connection port 140 is disposed. A discharge area 103c connected to the pump 160 is formed inside the second tank body 108 below the water level checking area.

The inlet flow path 146 and the outlet flow path 148 are formed in the connection port 140. The outlet flow path 148 is bent and extended forward. The outlet flow path 148 leads to the discharge port 122 located at the front.

The outlet flow path 148 is disposed above the inlet flow path 146. The sensor groove 152 is disposed between the outlet flow path 148 and the inlet flow path 146. The sensor cover 120 is disposed in front of the sensor groove 152. The sensor cover 120 may have a shape that protrudes forward. The sensor cover 120 is disposed below the discharge port 122.

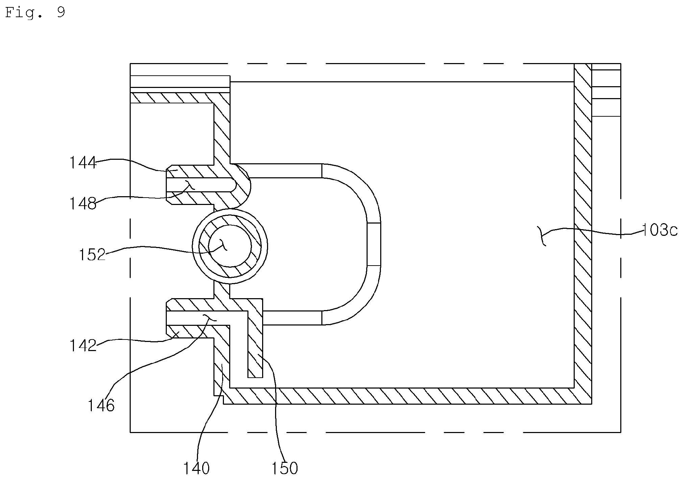

Referring to FIG. 9, the structure of the inlet flow path 146 will be described.

The connection port 140 is disposed on one side of the space formed by the second tank body 108. The inlet port 142 and the outlet port 144 are disposed in the connection port 140 to protrude in the direction in which the pump 160 is disposed. The inlet flow path 146 may be formed inside the inlet port 142. The outflow flow path 148 may be formed inside the outlet port 144.

An inner pipe 150 is disposed inside the second tank body 108. The inner pipe 150 extends from the connection port 140 to the inner side and lower side of the second tank body 108. Accordingly, the detergent present in the lower area of the second tank body 108 may be discharged by the pump 160.

The inlet flow path extends into the interior of the inner pipe 150. Therefore, the inlet flow path 146 has a structure that bends downward from the interior of the second tank body 108.

The sensor groove 152 into which the temperature sensor 250 is inserted is formed in the second tank body 108. The sensor groove 152 is disposed between the inlet flow path 146 and the outlet flow path 148 in the up-down direction.

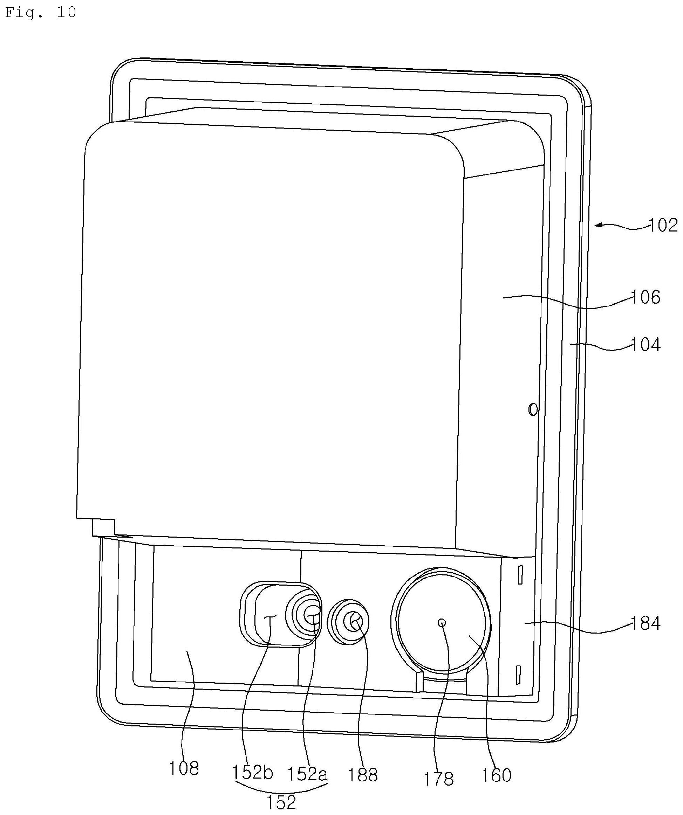

Referring to FIG. 10, the pump 160 and the pump cover 184 mounted to the detergent tank 102 will be described.

The pump 160 is disposed on one side of the detergent tank 102. The pump 160 is connected to the detergent tank 102 and sends the detergent stored in the detergent tank 102 to the tub 14.

The pump 160 is formed with the gear groove 178 into which the transmission gear 230 is inserted on the rear surface of the pump. The pump 160 is formed with the detection sensor groove 152 in which the detection sensor 252 for detecting operation of the pump 160 is disposed.

The pump cover 184 may fix the position of the pump 160. The pump cover 184 is disposed so as to be fixed to the detergent tank 102. A fastening hole 188 is formed in the pump cover 184 to be fastened to the detergent tank 102 by a separate fastening means.

A pump hole 186 is formed in the pump cover 184 so that one side of the pump 160 is exposed.

In a state where the pump 160 and the pump cover 184 are mounted to the detergent tank 102, the pump cover 184 may form a surface identical to that of the second tank body 108.

The length of the second tank body 108 protruding rearward from the first wall 104 may be formed to be equal to the length of the pump cover 184 mounted to the detergent tank 102 protruding rearward from the first wall 104.

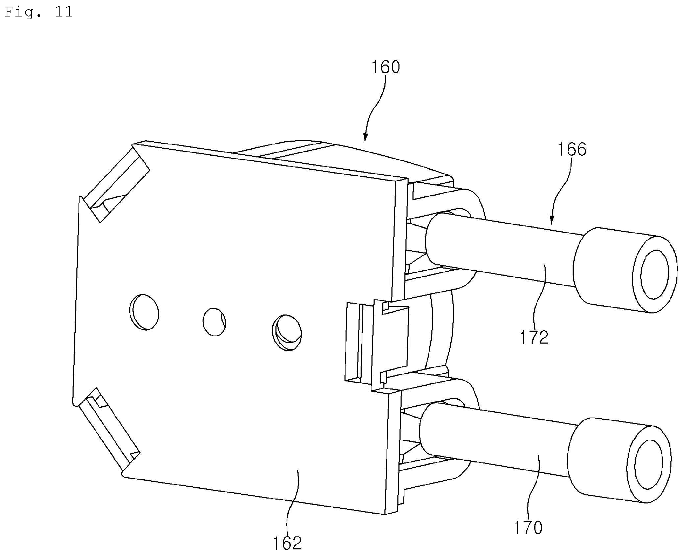

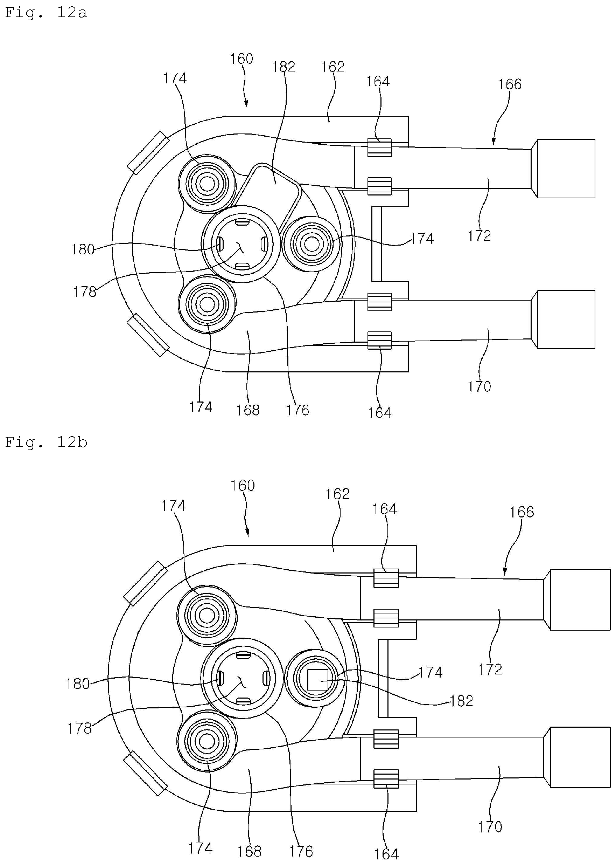

The pump 160 will be described with reference to FIGS. 11, 12a, and 12b.

The pump 160 includes a pump tube 166 connected to the detergent tank 102 and a plurality of pressure rollers 174 that pressurize and rotate the pump tube 166. The pump 160 includes a rotor 176 that rotates the plurality of pressure rollers 174. The pump 160 includes a pump housing 162 that fixes the disposition of the pump tube 166.

The rotor 176 is rotatably disposed in the pump housing 162. The rotor 176 is formed with the gear groove 178 into which the transmission gear 230 is inserted. The rotor 176 has a plurality of inner protrusions 180 disposed on the inner peripheral surface where the gear groove 178 is formed. The plurality of inner protrusions 180 are disposed spaced apart in the circumferential direction. Each of the plurality of inner protrusions 180 may have a hemispherical shape.

The rotor 176 rotates in connection with the transmission gear 230. The rotor 176 rotates the plurality of pressure rollers 174.

The pump 160 includes a magnet 182 that rotates by the rotor 176. The magnet 182 may be disposed between the plurality of pressure rollers 174 as illustrated in FIG. 12a. Moreover, as illustrated in FIG. 12b, the magnet may be disposed on any one of the plurality of pressure rollers 174.

The magnet 182 rotates together with the pressure rollers 174.

The pump housing 162 fixes the pump tube 166. A fixing protrusion 164 protruding to fix one side of the pump tube 166 is disposed on the pump housing 162.

The pump tube 166 is connected to one side of the detergent tank 102. The pump tube 166 is connected to the inlet port 142 on one side and to the outlet port 144 on the other side.

The pump tube 166 includes an extrusion tube 168 disposed in an area in contact with the plurality of pressure rollers 174, an inlet tube connected to each of one side of the extrusion tube 168 and the inlet port 142 of the detergent tank 102, and an outlet tube 172 connected to each of the other side of the extrusion tube 168 and the outlet port 144 of the detergent tank 102.

The extrusion tube 168 may have a bent shape. The extrusion tube 168 is disposed inside the pump housing 162.

The outlet tube 172 is disposed above the inlet tube 170. The outlet tube 172 is disposed parallel to the ground. Therefore, even when the operation of the pump 160 is stopped, the detergent disposed in the outlet tube 172 is not discharged to the discharge port.

The inner diameter of the pump tube 166 may be formed to be 1 mm or more and 5 mm or less. When the inner diameter of the pump tube 166 is less than 1 mm, the amount of detergent discharged through the pump 160 may be formed to be very small. Moreover, when the inner diameter of the pump tube 166 is less than 1 mm, the detergent disposed inside the pump tube 166 may harden quickly.

Additionally, when the outer diameter of the pump tube 166 exceeds 5mm, a problem may occur in which the pressure roller 174 does not operate when the detergent disposed inside the pump tube 166 hardens.

The outer diameter of the pump tube 166 may be formed to be 10mm or less. When the outer diameter of the pump tube 166 exceeds 10mm, the inner diameter of the pump tube 166 may exceed 5mm. Moreover, when the outer diameter of the pump tube 166 exceeds 10mm, in a case where the inner diameter of the pump tube 166 does not exceed 5mm, a problem may occur in which the thickness of the pump tube 166 becomes too thick, making it impossible to smoothly apply pressure by the pressure roller 174.

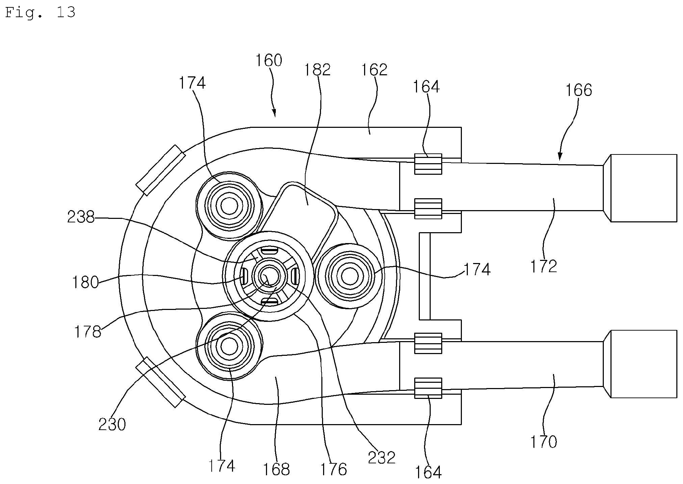

Referring to FIG. 13, a state in which the transmission gear 230 is mounted to the gear groove 178 will be described.

When the detergent tank 102 is mounted to the housing 200, one side of the transmission gear 230 is inserted into the gear groove 178.

A second gear 236 of the transmission gear 230, which will be described below, is disposed between the plurality of inner protrusions 180. The plurality of outer protrusions 238 formed by the second gear 236 may have a structure that protrudes radially outward from the transmission gear shaft 232 formed by the transmission gear 230.

The thickness of each of the plurality of outer protrusions 238 is formed to be smaller than the spacing between each of the plurality of inner protrusions 180. When the detergent tank 102 is mounted to the housing 200, the plurality of outer protrusions 238 may be naturally disposed between the plurality of inner protrusions 180.

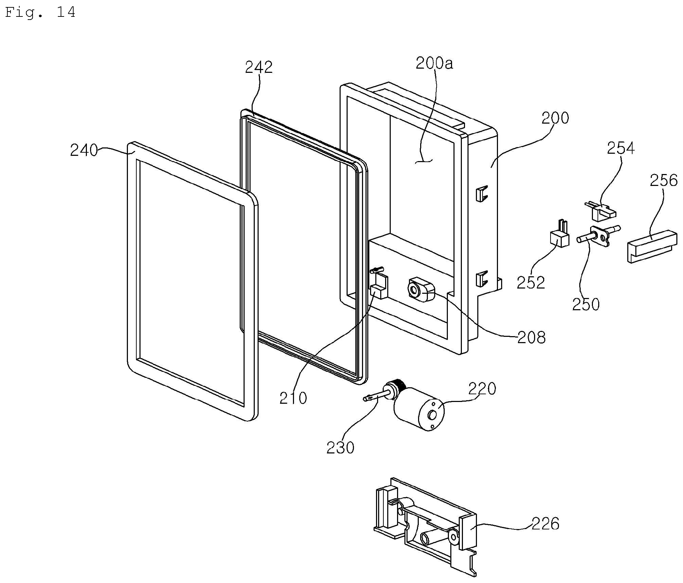

Referring to FIG. 14, the configurations of the housing 200 and the motor 220 will be described.

The housing 200 may be mounted to the door 10.

The housing 200 forms the mounting space 200a in which the detergent tank 102 is mounted. The housing 200 may have a structure corresponding to the shape of the first tank body 106 and the second tank body 108 of the detergent tank 102.

A first sealer 240 that seals the space between the housing 200 and the detergent tank 102 may be disposed on one side of the housing 200. A second sealer 242 that seals the space between the housing 200 and the door 10 may be disposed on the other side of the housing 200.

The temperature sensor 250 for detecting the temperature of the detergent discharged from the discharge port 122 is disposed in the housing 200.

The detection sensor 252 for detecting the rotation of the rotor 176 when the pump 160 is operated is disposed in the housing 200. The detection sensor 252 may use a Hall sensor that detects the magnet 182.

A water level sensor 254 for checking the position of the floater 128 may be disposed in the housing 200. The water level sensor 254 may detect the water level of the detergent tank 102 by checking the distance between the water level sensor and the floater 128 which is disposed in the detergent tank 102.

A mounting detection sensor 256 for detecting whether the detergent tank 102 is mounted may be disposed in the housing 200. A magnet (not illustrated) may be disposed inside the detergent tank 102. Accordingly, by detecting the magnet disposed in the detergent tank 102, the mounting detection sensor 256 may detect whether the detergent tank 102 is mounted.

The motor 220, the transmission gear 230, and the motor cover 226 are disposed on one side of the housing 200. The motor 220 is disposed in a direction perpendicular to the transmission gear 230. The motor cover 226 places the motor 220 on one side of the housing 200.

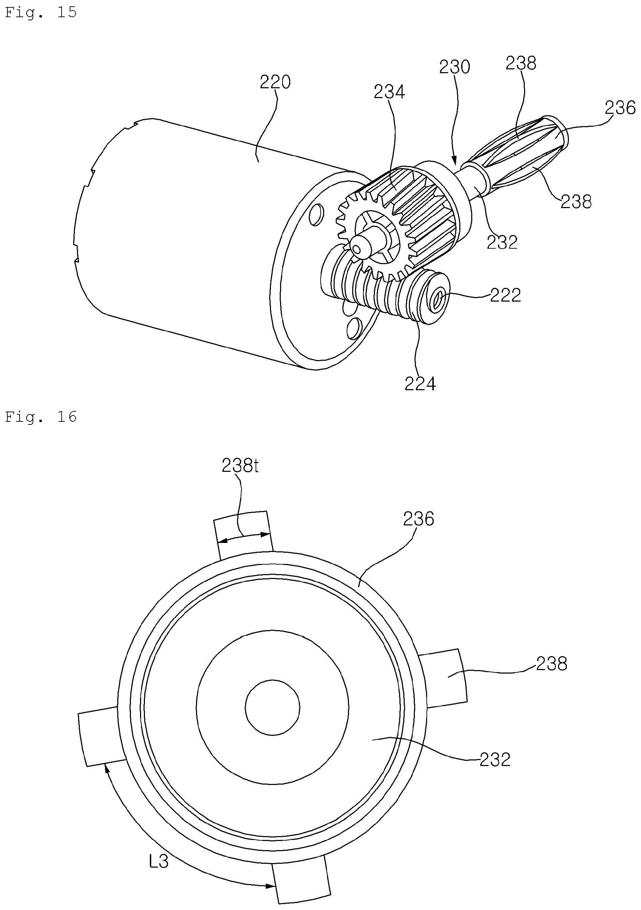

Referring to FIGS. 15 and 16, the configurations of the motor 220 and the transmission gear 230 will be explained.

The motor 220 rotates a motor shaft 222 by driving. A motor gear 224 protruding in a screw shape is disposed on the outer circumference of the motor shaft 222. The motor gear 224 may have the form of a worm gear.

The motor shaft 222 is disposed to extend in the left-right direction. Accordingly, the space occupied by the motor 220, which has a cylindrical shape, in the front-rear direction can be minimized.

The transmission gear 230 includes the transmission gear shaft 232 disposed perpendicular to the motor shaft 222, a first gear 234 disposed on one side of the transmission gear shaft 232 and meshing with the motor gear 224, and the second gear 236 disposed on the other side of the transmission gear shaft 232 and rotating the rotor 176.

The transmission gear 230 is disposed above the motor shaft 222. Unlike the drawings, the transmission gear 230 may be disposed below the motor shaft 222.

The first gear 234 is disposed to mesh with the motor gear 224. The first gear 234 may mesh with the motor gear 224 to convert the driving force from the motor 220 into a vertical direction.

The second gear 236 may be inserted into the gear groove 178 formed in the pump 160. The second gear 236 has the plurality of outer protrusions 238 disposed on the outer circumferential surface of the transmission gear shaft 232 and spaced apart in the circumferential direction.

The number of the plurality of outer protrusions 238 may be formed to be equal to the number of the plurality of inner protrusions 180 disposed on the rotor 176. Referring to FIG. 16, a thickness 238t formed by each of the plurality of outer protrusions 238 in the circumferential direction is formed to be smaller than a spacing L3 between the plurality of outer protrusions 238 in the circumferential direction.

Each of the plurality of outer protrusions 238 may be formed to extend long in the direction in which the transmission gear shaft 232 extends.

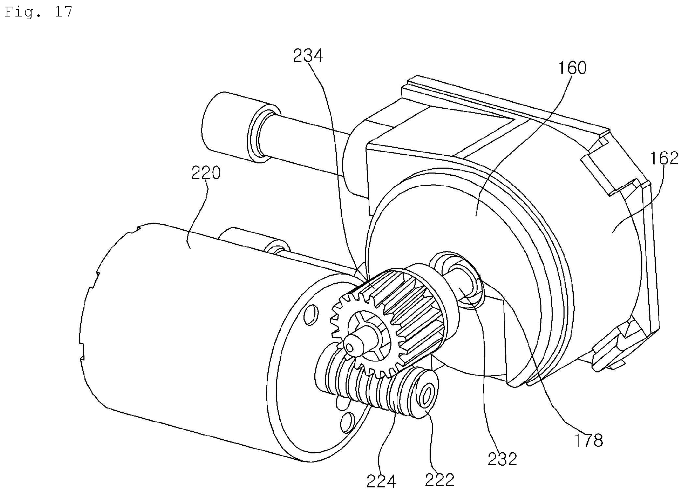

With reference to FIG. 17, the arrangement between the motor 220, the transmission gear 230, and the pump 160, and the operation of the pump 160 will be explained.

The motor shaft 222 is disposed perpendicularly to the transmission gear shaft 232. The rotor 176 of the pump 160 rotates with the transmission gear shaft 232 as the center of rotation.

The second gear 236 of the transmission gear 230 is inserted into the gear groove 178 of the pump 160. The motor shaft 222 is disposed perpendicularly to the transmission gear shaft 232. The rotor 176 of the pump 160 rotates with the transmission gear shaft 232 as the center of rotation.

The motor shaft 222 rotates due to the operation of the motor 220, and the second gear 236, which meshes with the motor gear 224, rotates.

The motor gear 224 has a worm gear structure, and the second gear 236 has a structure corresponding to a worm wheel. Therefore, as the motor shaft 222 rotates multiple times due to the operation of the motor 220, the second gear 236 may rotate partially. That is, precise control of the pump 160 by the motor 220 is possible. In addition, the pump 160 may be driven even with a small force from the motor 220. Therefore, even when the motor 220 of small size and specifications is used, the pump 160 may be operated precisely.

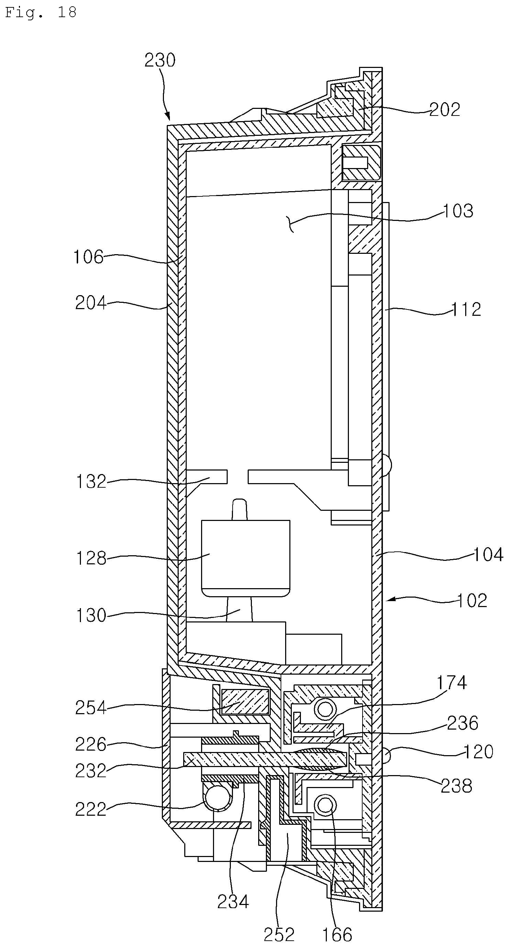

Referring to FIG. 18, the disposition of the transmission gear 230 when the detergent tank 102 is mounted to the housing 200 will be described.

When the detergent tank 102 is mounted to the housing 200, the first sealer 240 is disposed between the detergent tank 102 and the housing 200.

When the detergent tank 102 is mounted to the housing 200, the floater 128 is disposed above the water level sensor 254.

When the detergent tank 102 is mounted to the housing 200, the transmission gear 230 is inserted into the gear groove 178. When the detergent tank 102 is mounted to the housing 200, the second gear 236 of the transmission gear 230 is inserted into the gear groove 178.

When the detergent tank 102 is mounted to the housing 200, the detection sensor 252 is disposed below the pump 160.

The detection sensor 252 is disposed below the pump 160 and may detect the magnet 182 disposed on the pump 160. The detection sensor 252 may detect whether the pump 160 is operating by detecting the magnet 182 disposed on the pump 160.

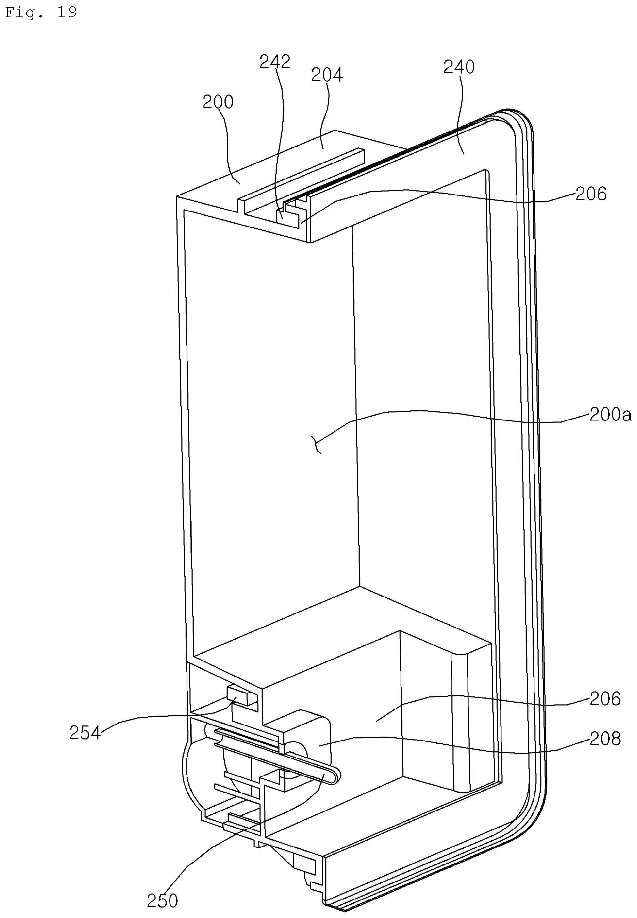

Referring to FIG. 19, the structure of the housing 200 and the disposition of the temperature sensor will be described.

The housing 200 forms the mounting space 200a in which the detergent tank 102 is disposed.

The housing 200 includes a perimeter wall 202, the first housing body 204 protruding rearward from the perimeter wall 202, and the second housing body 206 protruding rearward from the perimeter wall 202 and disposed below the first housing body 204.

The first sealer 240 is disposed in front of the perimeter wall 202. The second sealer 242 is disposed behind the perimeter wall 202. The perimeter wall 202 forms the space into which a detergent tank 102 is inserted.

The first housing body 204 forms the space into which the first tank body 106 is disposed. The second housing body 206 forms the space into which the second tank body 108 is disposed. The space formed by the second tank body 108 may be formed to be smaller than the space formed by the first tank body 106.

The motor 220 is disposed behind the second housing body 206. The temperature sensor 250 is disposed in the second housing body 206. The water level sensor 254 is disposed behind the second housing body 206. The water level sensor 254 is disposed above the temperature sensor 250.

The sensor mounting portion 208 in which the temperature sensor 250 is disposed is disposed in the second housing body 206. The sensor mounting portion 208 has a structure that protrudes forward from the second housing body 206. The sensor mounting portion 208 protrudes forward with a width greater than the width formed by the temperature sensor 250.

The temperature sensor 250 is disposed to protrude forward relative to the sensor mounting portion 208.

The detection sensor 252 (refer to FIG. 18) is disposed behind the second housing body 206. The detection sensor mounting portion 210 that protrudes forward from the area in which the detection sensor 252 is disposed is disposed on one side of the second housing body 206.

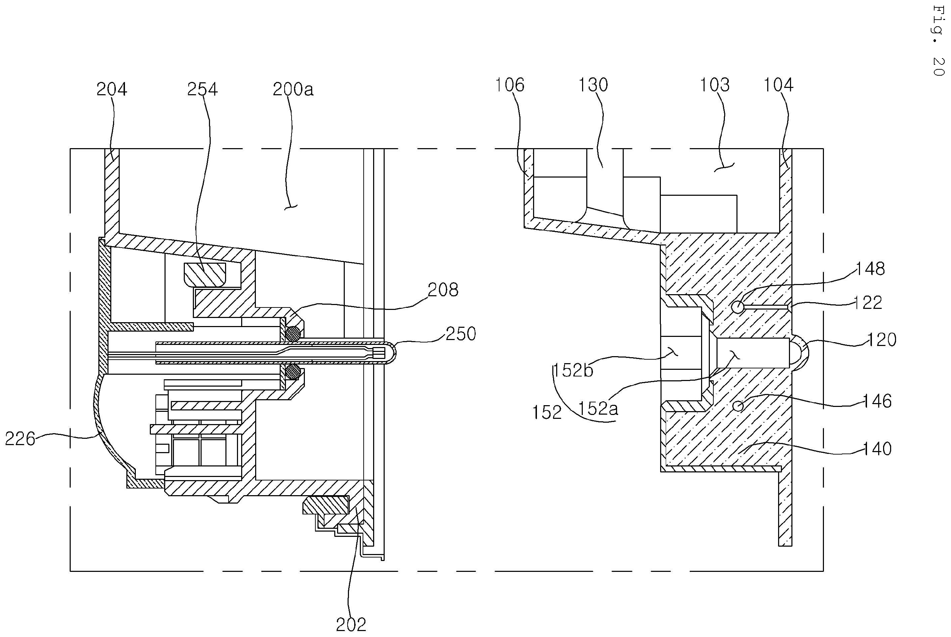

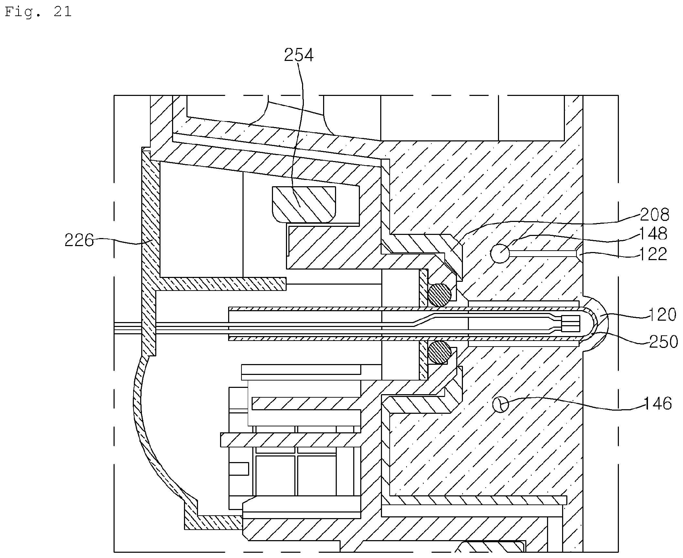

Referring to FIGS. 20 and 21, the disposition of the temperature sensor 250 when the detergent tank 102 is mounted to the housing 200 will be described.

When the detergent tank 102 is mounted to the housing 200, the temperature sensor 250 is inserted into the first sensor groove 152a. When the detergent tank 102 is mounted to the housing 200, the sensor mounting portion 208 is inserted into the second sensor groove 152b.

When the detergent tank 102 is mounted to the housing 200, one side of the temperature sensor 250 is disposed to be in contact with the sensor cover 120.

The temperature sensor 250 is disposed below the outlet flow path 148. The temperature sensor 250 is disposed below the discharge port 122. The sensor cover 120 is disposed to protrude forward from the detergent tank 102. The sensor cover 120 is disposed below the discharge port 122.

The temperature sensor 250 is disposed between the outlet flow path 148 and the inlet flow path 146.

When the detergent tank 102 is mounted to the housing 200, the water level sensor 254 is disposed below the floater 128. Accordingly, the water level sensor 254 may detect the water level of the detergent tank 102 by detecting the distance between the water level sensor and the floater 128.

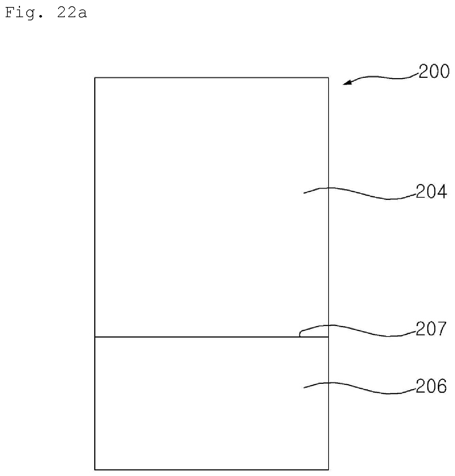

Hereinafter, various forms of the first housing body 204 and the second housing body 206 of the housing according to various embodiments of the present disclosure will be described with reference to FIGS. 22a to 22d.

Referring to FIG. 22a, in the housing 200 according to a first embodiment, the first housing body 204 is disposed above the second housing body 206. This may have the same form as the housing 200 described in FIGS. 3, 14, and 19. Accordingly, a stepped portion 207 may be formed between the first housing body 204 and the second housing body 206.

According to the form of the housing 200, the form of the detergent tank 102 may also be changed to a corresponding form. That is, the first tank body 106 may be disposed in an area in which the first housing body 204 is formed, and the second tank body 108 may be disposed in an area in which the second housing body 206 is formed.

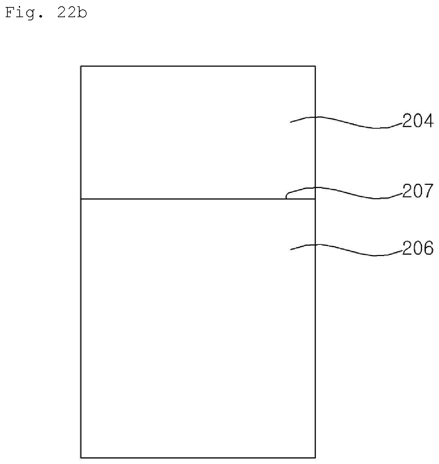

Referring to FIG. 22b, the second housing body 206 may also be disposed above the first housing body 204. The stepped portion 207 is also formed between the first housing body 204 and the second housing body 206. In this case, the first tank body 106 of the detergent tank 102 may be disposed below the second tank body 108.

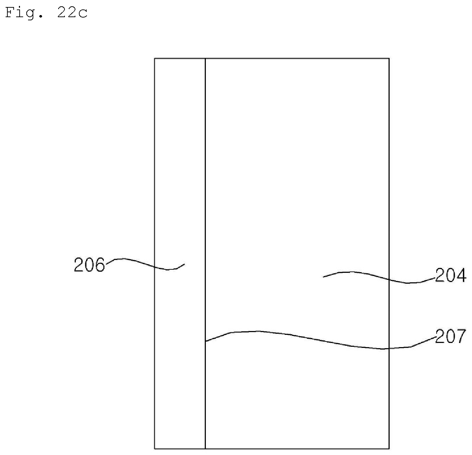

Referring to FIG. 22c, the first housing body 204 and the second housing body 206 may be disposed on both sides. The stepped portion 207 partitioning the first housing body 204 and the second housing body 206 may be formed in the un-down direction.

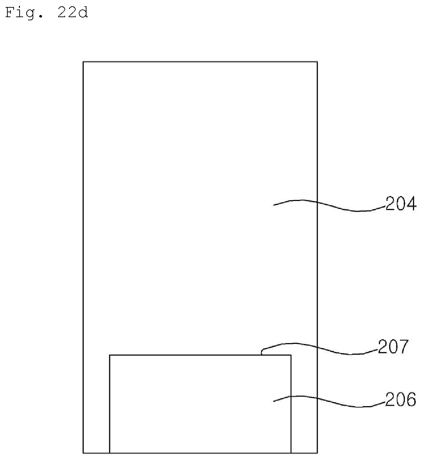

Referring to FIG. 22d, the second housing body 206 may be disposed in one area below the first housing body 204. By minimizing the area in which the second housing body 206 is disposed, a space for detergent stored in the detergent tank 102 may be secured as much as possible. In this case, the stepped portion 207 may be formed in a "U"-shape as illustrated in the drawing.

Although preferred embodiments of the present disclosure have been illustrated and described above, the present disclosure is not limited to the specific embodiments described above, and various modifications are possible by those skilled in the art to which the invention belongs without departing from the essence of the present disclosure claimed in the patent claims, and such modifications should not be understood individually from the technical concept or perspective of the present disclosure.

## Claims

1. A dishwasher comprises:
a tub that forms a washing space in which dishes are placed, and has one open side;
a door that is arranged on one side of the tub, and opens and closes the one open side of the tub; and
a detergent supply device that supplies detergent to the washing space,
wherein the detergent supply device includes
a detergent tank that forms a storage space in which detergent is stored,
a housing that forms a mounting space in which the detergent tank is mounted,
a pump that is mounted on one side of the detergent tank, and sends the detergent stored in the storage space to the washing space, and
a motor that operates the pump,
the door includes an inner door disposed to face the washing space when the door is closed,
the inner door includes a recessed portion and a protruding portion protruding toward the tub relative to the recessed portion, and the housing is disposed on one side of the protruding portion,
the housing includes a first housing body forming a first mounting space, a second housing body disposed on one side of the first housing body and forming a second mounting space having a depth different from that of the first mounting space, and a stepped portion disposed to form a step between the first housing body and the second housing body, and
an end portion of the stepped portion is disposed between a surface formed by the protruding portion and a surface formed by the recessed portion.

2. The dishwasher of claim 1, wherein the second housing body is provided with a device that detects a state of the detergent tank or the pump or is linked to the detergent tank or the pump.

3. The dishwasher of claim 2, wherein the device includes one of a detection sensor for detecting operation of the pump, a temperature sensor for detecting a temperature of detergent discharged from the detergent tank, and a transmission gear connected to the pump.

4. The dishwasher of claim 1, wherein the second housing body is positioned below the first housing body.

5. The dishwasher of claim 2, wherein the device protrudes from the second housing body in a direction in which the detergent tank is disposed.

6. The dishwasher of claim 1, wherein the door includes an outer door positioned outside the inner door, and
the protrusion includes an installation portion on which an additional detergent supply device is disposed, and the installation portion is disposed closer to the outer door than the protrusion.

7. The dishwasher of claim 1, wherein the pump includes
a pump tube that is connected to the detergent tank to supply the detergent stored in the detergent tank to the washing space, and
a plurality of pressure rollers that are connected to the motor to rotate and pressurize one side of the pump tube, and
the pump tube has a partial area disposed horizontally, which sends the detergent flowing by the pressure rollers to a discharge port of the detergent tank.

8. The dishwasher of claim 1, further comprising a transmission gear configured to transmit a driving force generated from the motor to the pump,
wherein the pump is provided with a gear groove into which a portion of the transmission gear is inserted, and
when the detergent tank is mounted on the housing, the motor into which a portion of the transmission gear is inserted is connected to the gear groove formed in the pump.

9. The dishwasher of claim 8, wherein the motor includes a motor shaft and a motor gear protruding in a screw shape from an outer circumference of the motor shaft, and
the transmission gear includes a transmission gear shaft disposed perpendicular to the motor shaft, a first gear disposed on one side of the transmission gear shaft and engaged with the motor gear, and a second gear disposed on the other side of the transmission gear shaft and connected to the pump.

10. A dishwasher comprising:
a tub that forms a washing space in which dishes are placed, and has one open side;
a door that is arranged on one side of the tub, and opens and closes the one open side of the tub; and
a detergent supply device that supplies detergent to the washing space,
wherein the detergent supply device includes
a detergent tank that forms a storage space in which detergent is stored,
a housing that forms a mounting space in which the detergent tank is mounted,
a pump that is disposed on one side of the detergent tank, and sends the detergent stored in the storage space to the washing space,
a motor that is disposed on one side of the housing and operates the pump, and
a transmission gear that transmits a driving force of the motor to the pump,
the motor includes a motor shaft configured to rotate when driven and a motor gear forming a screw-shaped thread on a circumferential surface of the motor shaft, and
the transmission gear includes a transmission gear shaft disposed perpendicular to the motor shaft, a first gear disposed on one side of the transmission gear shaft and engaged with the motor gear, and a second gear disposed on the other side of the transmission gear shaft and connected to the pump.

11. The dishwasher of claim 10,
wherein the pump includes
a pump tube connected to the detergent tank and forming a space through which the detergent flows,
a pressure roller that pressurizes one side of the pump tube to cause the detergent inside the pump tube to flow, and
a rotor configured to rotate the pressure roller, the rotor being provided with a gear groove at one side thereof into which the transmission gear is inserted.

12. The dishwasher of claim 11,
wherein an inner circumferential surface of the gear groove is provided with a plurality of inner protrusions protruding inward, and
the second gear is provided with a plurality of outer protrusions protruding from an outer peripheral surface of the transmission gear shaft while being spaced apart from each other in a circumferential direction.

13. The dishwasher of claim 12, wherein a thickness formed by the plurality of outer protrusions in the circumferential direction is smaller than a spacing between the plurality of outer protrusions.

14. The dishwasher of claim 12, wherein a thickness of each of the plurality of outer protrusions is smaller than a spacing between the plurality of inner protrusions.

15. A dishwasher comprising:
a tub that forms a washing space in which dishes are placed, and has one open side;
a door that is arranged on one side of the tub, and opens and closes the one open side of the tub; and
a detergent supply device that supplies detergent to the washing space,
wherein the detergent supply device includes
a detergent tank that forms a storage space in which detergent is stored,
a housing that forms a mounting space in which the detergent tank is mounted,
a pump that is disposed on one side of the detergent tank, and sends the detergent stored in the storage space to the washing space, and
a motor that is disposed on one side of the housing and operates the pump,
wherein the pump includes
a pump tube connected to the detergent tank and supplying detergent stored in the detergent tank to the washing space, and
a plurality of pressure rollers connected to the motor and rotating to pressurize one side of the pump tube, and
the detergent supply device includes a detection sensor configured to detect operation of the pump, and the detection sensor is installed in the housing.

16. The dishwasher of claim 15, wherein the detection sensor is installed at a rear side of the housing.

17. The dishwasher of claim 16, wherein the housing is provided with a detection sensor mounting portion protruding forward in an area in which the detection sensor is disposed.

18. The dishwasher of claim 15, wherein the housing includes a first housing body and a second housing body disposed on one side of the first housing body and protruding outward relative to the first housing body, and
the detection sensor is installed in the second housing body.

19. The dishwasher of claim 18, wherein the second housing body protrudes lower than the first housing body.

20. The dishwasher of claim 15, wherein the pump includes a magnet rotating together according to rotation of the pressure roller, and the detection sensor determines a rotation state and an operation state of the pump by detecting a change in magnetic force of the magnet.
